# EUROPEAN PATENT APPLICATION

(11) **EP 4 744 924 A1**
(43) Date of publication of application: **20.05.2026**
(21) Application number: 23946526.3
(22) Date of filing: 26.12.2023
(51) Int. Cl.: B60K 1/02, B60K 17/06, B60L 15/20

(54) **MOTOR CONTROLLER, ELECTRIC DRIVE APPARATUS, ELECTRIC DRIVE SYSTEM, AND ELECTRIC DEVICE**

(30) Priority: 25.07.2023 CN 202321975117 U
(71) Applicant: Contemporary Amperex Intelligence Technology (Shanghai) Limited, Shanghai 201306 (CN)
(72) Inventor: HUANG, Zhinian, Shanghai 201306 (CN); SHAN, Liang, Shanghai 201306 (CN); ZHANG, Junhui, Shanghai 201306 (CN)
(74) Representative: Gong, Jinping
(86) International application number: PCT/CN2023/142092
(87) International publication number: WO 2025/020451

(57) **Abstract**

The present application provides a motor controller (11), an electric drive apparatus (10), an electric drive system (100), and an electric device. The motor controller (11) includes a first control assembly (111), a second control assembly (112), and a cooling assembly (113). The first control assembly (111) is electrically connected to a first motor (12). The second control assembly (112) is electrically connected to a second motor (13). The cooling assembly (113) is configured to cool the first control assembly (111) and the second control assembly (112). The first control assembly (111), the cooling assembly (113), and the second control assembly (112) are sequentially stacked.

## Description

### CROSS-REFERENCE TO RELATED APPLICATIONS

The present application claims priority to Chinese Patent Application No. 202321975117.2, filed on July 25, 2023 and entitled "MOTOR CONTROLLER, ELECTRIC DRIVE APPARATUS, ELECTRIC DRIVE SYSTEM, AND ELECTRIC DEVICE", which is incorporated herein by reference in its entirety.

### TECHNICAL FIELD

The present application pertains to the field of electric drive technologies and more specifically relates to a motor controller, an electric drive apparatus, an electric drive system, and an electric device.

### BACKGROUND

With the increasing severity of environmental pollution, new energy vehicles are gaining more and more popularity. An electric drive apparatus, as a power apparatus of a new energy vehicle, is configured to convert electrical energy provided by a battery into mechanical energy to drive the new energy vehicle to travel. The electric drive apparatus typically includes a motor and a motor controller, where the motor controller is configured to control the operation of the motor. However, due to a large number of components and complex structure of the motor controller, how to make the assembly of the motor controller simple and the structure compact has become an urgent problem to be solved in the art.

### SUMMARY

Embodiments of the present application are intended to provide a motor controller, an electric drive apparatus, an electric drive system, and an electric device, so as to solve the technical problem of complex structure of the motor controller in the related art.

To achieve the above purpose, the technical solution adopted by the embodiments of the present application is to provide a motor controller, including:
a first control assembly electrically connected to a first motor;
a second control assembly electrically connected to a second motor; and
a cooling assembly configured to cool the first control assembly and the second control assembly, where the first control assembly, the cooling assembly, and the second control assembly are sequentially stacked.

The motor controller provided by the embodiments of the present application has at least the following beneficial effects: in the motor controller provided by the embodiments of the present application, by sequentially stacking the first control assembly, the cooling assembly, and the second control assembly, the first control assembly and the second control assembly can share one cooling assembly, effectively reducing the number of components of the motor controller. Moreover, compared with a method of arranging multiple control assemblies in a dispersed manner, the method of sequentially stacking the first control assembly, the cooling assembly, and the second control assembly can make the structure of the motor controller more compact, thereby effectively reducing the volume of the motor controller, and further effectively reducing the volume of an electric drive apparatus using the motor controller.

In some embodiments of the present application, the motor controller is disposed between the first motor and the second motor.

By adopting the above technical solution, the space between the first motor and the second motor can be effectively utilized, thereby further reducing the volume of the electric drive apparatus.

In some embodiments of the present application, the first control assembly, the cooling assembly, and the second control assembly are sequentially stacked along a first direction, where the first direction is a direction perpendicular to a central axis of the first motor and a central axis of the second motor.

By adopting the above technical solution, a thickness direction of an entirety formed by stacking the first control assembly, the cooling assembly, and the second control assembly corresponds to a depth direction of the space between the first motor and the second motor, while a width direction or length direction of the entirety formed by stacking the first control assembly, the cooling assembly, and the second control assembly corresponds to a width direction of the space between the first motor and the second motor. This can more effectively utilize the space between the first motor and the second motor, thereby further reducing the volume of the electric drive apparatus.

In some embodiments of the present application, the motor controller further includes a capacitor electrically connected to the first control assembly and the second control assembly, and a direct current input assembly electrically connected to the capacitor, where the first control assembly, the second control assembly, and the cooling assembly are disposed on one side of the capacitor, and the direct current input assembly is disposed on a side of the capacitor facing away from the first control assembly, the second control assembly, and the cooling assembly.

By adopting the above technical solution, the entirety formed by stacking the first control assembly, the cooling assembly, and the second control assembly, the capacitor, and the direct current input assembly are sequentially arranged along one direction, making the structure of the motor controller more compact, thereby further reducing the volume of the motor controller and further reducing the volume of the electric drive apparatus. In addition, the capacitor is disposed between the entirety formed by stacking the first control assembly, the cooling assembly, and the second control assembly and the direct current input assembly, so that the magnetic interference of the direct current input assembly on the first control assembly and the second control assembly is effectively alleviated, thereby effectively improving the reliability of the motor controller.

In some embodiments of the present application, the first control assembly, the second control assembly, and the cooling assembly are disposed on one side of the capacitor along a second direction, and the direct current input assembly is disposed on the other side of the capacitor along the second direction, where the second direction is a direction perpendicular to the first direction, the central axis of the first motor, and the central axis of the second motor.

By adopting the above technical solution, the motor controller is generally in a cuboid structure, thereby making the structure of the motor controller more compact and further reducing the volume of the motor controller. In addition, a width direction of the motor controller corresponds to the width direction of the space between the first motor and the second motor. This can more effectively utilize the space between the first motor and the second motor, thereby further reducing the volume of the electric drive apparatus.

In some embodiments of the present application, the motor controller further includes a first electrical connection member, where a first alternating current output terminal is disposed on a side of the first control assembly facing away from the capacitor, one end of the first electrical connection member is electrically connected to the first alternating current output terminal, and the other end of the first electrical connection member extends from the first alternating current output terminal to a side of the first control assembly facing the first motor and is electrically connected to an alternating current input terminal of the first motor; and/or the motor controller further includes a second electrical connection member, where a second alternating current output terminal is disposed on a side of the second control assembly facing away from the capacitor, one end of the second electrical connection member is electrically connected to the second alternating current output terminal, and the other end of the second electrical connection member extends from the second alternating current output terminal to a side of the second control assembly facing the second motor and is electrically connected to an alternating current input terminal of the second motor.

By adopting the above technical solution, the layout design of a direct current-alternating current conversion circuit of a first control module is facilitated, and an alternating current transmission path between the first control assembly and the first motor can be effectively shortened, thereby further reducing the volume of the motor controller. Similarly, the layout design of a direct current-alternating current conversion circuit of a second control module is facilitated, and an alternating current transmission path between the second control assembly and the second motor can be effectively shortened, thereby further reducing the volume of the motor controller.

In some embodiments of the present application, the motor controller further includes a first sampling harness, where a first sampling terminal is disposed on the side of the first control assembly facing the first motor, one end of the first sampling harness is electrically connected to the first sampling terminal, and the other end of the first sampling harness is electrically connected to a sampling terminal of the first motor; and/or the motor controller further includes a second sampling harness, where a second sampling terminal is disposed on the side of the second control assembly facing the second motor, one end of the second sampling harness is electrically connected to the second sampling terminal, and the other end of the second sampling harness is electrically connected to a sampling terminal of the second motor.

By adopting the above technical solution, a sampling path between the first control assembly and the first motor is effectively shortened, thereby further reducing the volume of the motor controller. Similarly, a sampling path between the second control assembly and the second motor is effectively shortened, thereby further reducing the volume of the motor controller.

In some embodiments of the present application, the motor controller further includes a box, a capacitor electrically connected to the first control assembly and the second control assembly, and a direct current input assembly electrically connected to the capacitor, where the first control assembly, the second control assembly, the cooling assembly, the capacitor, and the direct current input assembly are accommodated in the box.

By adopting the above technical solution, the first control assembly, the second control assembly, the cooling assembly, the capacitor, and the direct current input assembly are effectively protected.

In some embodiments of the present application, the first control assembly, the second control assembly, the cooling assembly, the capacitor, and the direct current input assembly are connected and integrated into an entirety.

By adopting the above technical solution, the first control assembly, the second control assembly, the cooling assembly, the capacitor, and the direct current input assembly are connected into an entirety and then assembled into the box, thereby effectively improving the assembly efficiency of the motor controller.

In some embodiments of the present application, the motor controller further includes a first electrical connection member and a second electrical connection member, where one end of the first electrical connection member is electrically connected to the first control assembly, and the other end of the first electrical connection member is detachably connected to an alternating current input terminal of the first motor; one end of the second electrical connection member is electrically connected to the second control assembly, and the other end of the second electrical connection member is detachably connected to an alternating current input terminal of the second motor; an inner wall of the box is provided with a liquid inlet connector, a liquid outlet connector, and a direct current input terminal; the cooling assembly includes a liquid inlet pipe detachably connected to the liquid inlet connector and a liquid outlet pipe detachably connected to the liquid outlet connector; and the direct current input assembly includes a third electrical connection member detachably connected to the direct current input terminal.

By adopting the above technical solution, when maintenance of the motor controller is required, the first electrical connection member can be detached from the alternating current input terminal of the first motor, the second electrical connection member can be detached from the alternating current input terminal of the second motor, the liquid inlet pipe can be detached from the liquid inlet connector, the liquid outlet pipe can be detached from the liquid outlet connector, and the third electrical connection member can be detached from the direct current input terminal; and then the entirety formed by connecting the first control assembly, the second control assembly, the cooling assembly, the capacitor, and the direct current input assembly can be taken out from the box, so as to facilitate maintenance of one or more of the first control assembly, the second control assembly, the cooling assembly, the capacitor, and the direct current input assembly.

In some embodiments of the present application, the first control assembly includes a first power module and a first control module; the second control assembly includes a second power module and a second control module; and the first control module, the first power module, the cooling assembly, the second power module, and the second control module are sequentially stacked.

By adopting the above technical solution, the structure of the motor controller can be made more compact, effectively reducing the volume of the motor controller, thereby effectively reducing the volume of the electric drive apparatus using the motor controller.

In some embodiments of the present application, the cooling assembly includes a liquid cooling plate, where a cooling flow channel is provided inside the liquid cooling plate; the first power module includes a first power body and a first heat conduction member, where the first heat conduction member is disposed on a side of the first power body facing the liquid cooling plate and inserted into the cooling flow channel; and/or the second power module includes a second power body and a second heat conduction member, where the second heat conduction member is disposed on a side of the second power body facing the liquid cooling plate and inserted into the cooling flow channel.

By adopting the above technical solution, heat generated by operation of the first power body can be transferred to a cooling medium in the cooling flow channel through the first heat conduction member, thereby effectively improving the cooling efficiency of the cooling assembly on the first power module. In addition, the first heat conduction member is inserted into the cooling flow channel, the thickness of the entirety formed by stacking the first control assembly, the cooling assembly, and the second control assembly can be effectively reduced, thereby making the structure of the motor controller more compact and further reducing the volume of the motor controller. Similarly, heat generated by operation of the second power body can be transferred to the cooling medium in the cooling flow channel through the second heat conduction member, thereby effectively improving the cooling efficiency of the cooling assembly on the second power module. In addition, the second heat conduction member is inserted into the cooling flow channel, the thickness of the entirety formed by stacking the first control assembly, the cooling assembly, and the second control assembly can be effectively reduced, thereby making the structure of the motor controller more compact and further reducing the volume of the motor controller.

In some embodiments of the present application, the first control module includes a first circuit board, where the first circuit board is provided with a first drive circuit and a first control circuit; and/or the second control module includes a second circuit board, where the second circuit board is provided with a second drive circuit and a second control circuit.

By adopting the above technical solution, the integration degree of the motor controller is effectively improved, thereby further reducing the volume of the motor controller.

Embodiments of the present application further provide an electric drive apparatus including a first motor, a second motor, and the motor controller according to any one of the above embodiments, where the first control assembly is electrically connected to the first motor, and the second control assembly is electrically connected to the second motor.

The electric drive apparatus provided by the embodiments of the present application has at least the following beneficial effects: since the electric drive apparatus provided by the embodiments of the present application adopts the motor controller according to any one of the above embodiments, the volume of the electric drive apparatus is effectively reduced.

Embodiments of the present application further provide an electric drive apparatus including a first motor, a second motor, a transmission mechanism, and the motor controller according to the above embodiments, where the first control assembly is electrically connected to the first motor, the second control assembly is electrically connected to the second motor, and the motor controller and the transmission mechanism are arranged along a third direction, where the third direction is a direction perpendicular to a central axis of the first motor and a central axis of the second motor.

The electric drive apparatus provided by the embodiments of the present application has at least the following beneficial effects: since the electric drive apparatus provided by the embodiments of the present application adopts the motor controller according to the above embodiments, the volume of the electric drive apparatus is effectively reduced.

In some embodiments of the present application, the first direction and the third direction are the same.

By adopting the above technical solution, a stacking direction of the first control assembly, the cooling assembly, and the second control assembly is the same as a distribution direction of the motor controller and the transmission mechanism, so that the thickness direction of the entirety formed by stacking the first control assembly, the cooling assembly, and the second control assembly is consistent with a length direction of the electric drive apparatus, thereby effectively reducing the length of the electric drive apparatus and further reducing the volume of the electric drive apparatus.

Embodiments of the present application further provide an electric drive apparatus including a first motor, a second motor, a transmission mechanism, and the motor controller according to the above embodiments, where the first control assembly is electrically connected to the first motor, the second control assembly is electrically connected to the second motor, the transmission mechanism includes a first housing and a transmission assembly accommodated in the first housing, and the first housing and the box are integrally formed.

The electric drive apparatus provided by the embodiments of the present application has at least the following beneficial effects: since the electric drive apparatus provided by the embodiments of the present application adopts the motor controller according to the above embodiments, the volume of the electric drive apparatus is effectively reduced.

Embodiments of the present application further provide an electric drive system including a battery and the electric drive apparatus according to any one of the above embodiments, where the battery is electrically connected to the electric drive apparatus.

The electric drive system provided by the embodiments of the present application has at least the following beneficial effects: since the electric drive system provided by the embodiments of the present application adopts the electric drive apparatus according to any one of the above embodiments, the volume of the electric drive system is effectively reduced.

Embodiments of the present application further provide an electric device including the electric drive system described above.

The electric device provided by the embodiments of the present application has at least the following beneficial effects: since the electric device provided by the embodiments of the present application adopts the electric drive system according to any one of the above embodiments, the volume of the electric device is effectively reduced.

### BRIEF DESCRIPTION OF DRAWINGS

In order to more clearly illustrate the technical solutions in the embodiments of the present application, the drawings to be used in the embodiments or the related technical descriptions will be briefly introduced below. Obviously, the drawings in the following description are merely some embodiments of the present application. For those of ordinary skill in the art, other drawings can also be obtained based on these drawings without paying creative labor.
FIG. 1 is a schematic structural diagram of a vehicle according to an embodiment of the present application;
FIG. 2 is an exploded view of a battery according to an embodiment of the present application;
FIG. 3 is a schematic structural diagram of an electric drive apparatus according to an embodiment of the present application;
FIG. 4 is a schematic structural rear view of the electric drive apparatus shown in FIG. 3 after removing a cover of a motor controller;
FIG. 5 is a schematic structural diagram of the motor controller in the electric drive apparatus shown in FIG. 4 after removing a box, a cover, a first sampling harness, and a second sampling harness;
FIG. 6 is a schematic structural right view of the motor controller shown in FIG. 5 after removing a first electrical connection member, a second electrical connection member, and a liquid inlet pipe and a liquid outlet pipe of a cooling assembly;
FIG. 7 is a schematic structural diagram of a first control assembly in the motor controller shown in FIG. 6; and
FIG. 8 is a schematic structural diagram of a second control assembly in the motor controller shown in FIG. 6.

Reference signs in the drawings are as follows:
1000. vehicle;
100. electric drive system;
10. electric drive apparatus; 11. motor controller; 111. first control assembly; 1111. first control module; 1112. first power module; 11121. first power body; 11122. first heat conduction member; 112. second control assembly; 1121. second control module; 1122. second power module; 11221. second power body; 11222. second heat conduction member; 113. cooling assembly; 1131. liquid cooling plate; 1132. liquid inlet pipe; 1133. liquid outlet pipe; 114. capacitor; 115. direct current input assembly; 1151. third electrical connection member; 1152. EMC filter; 116a. first electrical connection member; 116b. second electrical connection member; 117a. first sampling harness; 117b. second sampling harness; 118. box; 1181. liquid inlet connector; 1182. liquid outlet connector; 1183. direct current input terminal; 12. first motor; 13. second motor; 14. transmission mechanism;
20. battery;
21. battery box; 211. first portion; 212. second portion;
22. battery cell; and
200. vehicle body.

### DESCRIPTION OF EMBODIMENTS

In order to make the technical problems to be solved, technical solutions, and beneficial effects of the present application clearer, the present application will be further described in detail below with reference to the drawings and embodiments. It should be understood that the specific embodiments described herein are merely used to explain the present application and are not intended to limit the present application.

It should be noted that when a component is referred to as being "fixed to" or "disposed on" another component, it can be directly on the another component or indirectly on the another component. When a component is referred to as being "connected to" another component, it can be directly connected to the another component or indirectly connected to the another component.

It should be understood that the orientation or positional relationships indicated by terms such as "length", "width", "upper", "lower", "front", "rear", "left", "right", "vertical", "horizontal", "top", "bottom", "inner", and "outer" are based on the orientation or positional relationships shown in the drawings, and are merely for convenience of describing the present application and simplifying the description, rather than indicating or implying that the referred apparatus or component must have a specific orientation, be constructed and operated in a specific orientation, and therefore cannot be understood as a limitation on the present application.

In addition, the terms "first", "second", and "third" are used for descriptive purposes only and cannot be understood as indicating or implying relative importance or implicitly indicating the number of indicated technical features. Thus, features defined with "first", "second", and "third" may explicitly or implicitly include one or more of the features. In the description of the present application, "multiple" means two or more, unless otherwise explicitly and specifically defined.

An electric drive apparatus can serve as a power apparatus of a new energy vehicle and is configured to convert electrical energy provided by a battery into mechanical energy to drive the new energy vehicle to travel. At present, the electric drive apparatus includes a centralized electric drive apparatus and a distributed electric drive apparatus, where the centralized electric drive apparatus transmits an output torque of a motor to left and right wheels of the new energy vehicle through a transmission mechanism to drive the new energy vehicle to travel, while the distributed electric drive apparatus typically includes at least two motors, where an output torque of each motor is transmitted to one wheel to drive the new energy vehicle to travel. In other words, the distributed electric drive apparatus can achieve independent control of individual wheels of the new energy vehicle. Therefore, compared with new energy vehicles using the centralized electric drive apparatus, new energy vehicles using the distributed electric drive apparatus have better functionality and maneuverability, making the distributed electric drive apparatus increasingly favored by automobile manufacturers.

In the related art, a distributed electric drive apparatus typically further includes a motor controller, where the motor controller includes at least two control assemblies and at least two cooling assemblies, each control assembly is electrically connected to one motor to control the corresponding motor to operate, and each cooling assembly is in heat conduction connection with one control assembly to cool the corresponding control assembly. However, since each control assembly requires one corresponding cooling assembly for cooling, a large number of cooling assemblies are required. In addition, the cooling assemblies have a large volume, thus increasing the volume of the motor controller. Moreover, to facilitate electrical connection of the control assemblies to the corresponding motors, the control assemblies are typically disposed at positions close to the corresponding motors, which leads to excessively dispersed positions of the control assemblies, thereby further increasing the volume of the motor controller, and thus significantly increasing the volume of the electric drive apparatus.

To reduce the volume of the motor controller, embodiments of the present application provide a motor controller, where a first control assembly, a cooling assembly, and a second control assembly of the motor controller are sequentially stacked, so that the first control assembly and the second control assembly can share one cooling assembly, effectively reducing the number of components of the motor controller. Moreover, compared with a method of arranging multiple control assemblies in a dispersed manner, the method of sequentially stacking the first control assembly, the cooling assembly, and the second control assembly can make the structure of the motor controller more compact, thereby effectively reducing the volume of the motor controller, and further effectively reducing the volume of an electric drive apparatus using the motor controller.

The electric drive apparatus provided by the embodiments of the present application can be applied to electric devices, where the electric devices may be but are not limited to vehicles, ships, aircraft, spacecraft, excavators, cranes, hoists, elevators, or the like, without specific limitation herein.

For ease of description, the following embodiments are described by taking an example in which an electric device according to an embodiment of the present application as a vehicle.

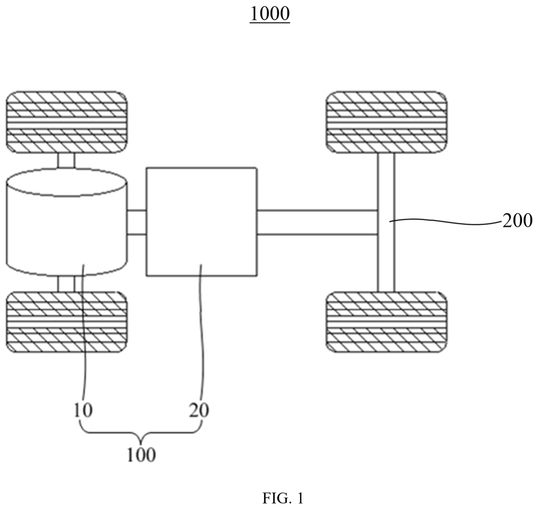

Referring to FIG. 1, FIG. 1 is a schematic structural diagram of a vehicle 1000 according to an embodiment of the present application. According to power sources, the vehicle 1000 may be a pure electric vehicle, a hybrid electric vehicle, an extended-range vehicle, or the like. According to drive modes, the vehicle 1000 may be a front-wheel drive vehicle, a rear-wheel drive vehicle, or a four-wheel drive vehicle. The vehicle 1000 includes a vehicle body 200 and an electric drive system 100.

The vehicle body 200 is a main support component of the vehicle 1000, and the vehicle body 200 has an engine compartment and a passenger compartment, where the engine compartment is configured to accommodate power mechanisms, electric control mechanisms, driving mechanisms, and the like of the vehicle 1000. The passenger compartment is configured to provide operating space and riding space for occupants. When the vehicle 1000 is a front-wheel drive vehicle, the engine compartment is disposed at the head of the vehicle body 200, that is, the engine compartment is a front engine compartment. When the vehicle 1000 is a rear-wheel drive vehicle, the engine compartment is disposed at the tail of the vehicle body 200, that is, the engine compartment is a rear engine compartment. When the vehicle 1000 is a four-wheel drive vehicle, the engine compartment is divided into a front engine compartment and a rear engine compartment, where the front engine compartment is disposed at the head of the vehicle body 200, and the rear engine compartment is disposed at the tail of the vehicle body 200. The passenger compartment is disposed between the head and the tail of the vehicle body 200.

The electric drive system 100 is a power system of the vehicle 1000, and the electric drive system 100 is configured to convert electrical energy into mechanical energy and output the mechanical energy to wheels of the vehicle 1000 to drive the vehicle 1000 to travel. The electric drive system 100 is disposed on the vehicle body 200. Specifically, a portion of the electric drive system 100 can be disposed in the engine compartment, and another portion of the electric drive system 100 can be disposed at the bottom of the vehicle body 200.

Referring to FIG. 1, the electric drive system 100 according to this embodiment of the present application includes a battery 20 and an electric drive apparatus 10.

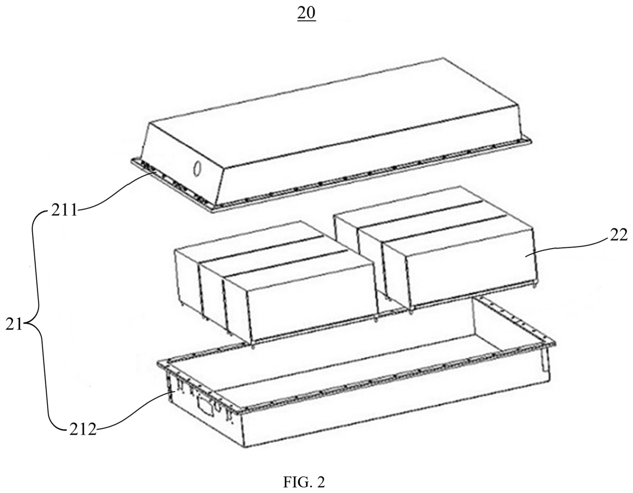

The battery 20 is configured to provide electrical energy for the electric drive apparatus 10, and the battery 20 may be disposed at the bottom, head, or tail of the vehicle 1000. Referring to FIG. 2, FIG. 2 is an exploded view of a battery 20 according to an embodiment of the present application. The battery 20 includes a battery box 21 and a battery cell 22, where the battery cell 22 is accommodated in the battery box 21. The battery box 21 is configured to provide an accommodation space for the battery cell 22, and the battery box 21 may adopt various structures. In some embodiments, the battery box 21 may include a first portion 211 and a second portion 212, where the first portion 211 and the second portion 212 fit each other, and the first portion 211 and the second portion 212 jointly define the accommodation space for accommodating the battery cell 22. The second portion 212 may be a hollow structure with an opening at one end, and the first portion 211 may be a plate-like structure. The first portion 211 covers an opening side of the second portion 212, so that the first portion 211 and the second portion 212 jointly define the accommodation space. The first portion 211 and the second portion 212 may alternatively each be a hollow structure with an opening on one side, and the opening side of the first portion 211 is engaged with the opening side of the second portion 212, so that the first portion 211 and the second portion 212 jointly define the accommodation space. Certainly, the battery box 21 formed by the first portion 211 and the second portion 212 may have various shapes, such as a cylinder and a cuboid, without specific limitation herein.

In some embodiments, the battery box 21 can serve as a portion of a chassis structure of the vehicle 1000. For example, a portion of the battery box 21 may become at least a portion of the floor of the vehicle 1000, or a portion of the battery box 21 may become at least a portion of a cross beam and longitudinal beam of the vehicle 1000.

Certainly, in some embodiments, the battery 20 may not include the battery box 21, but multiple battery cells 22 are electrically connected, form an entirety through essential fixing structures, and then are assembled into the vehicle 1000.

In the battery 20, there may be multiple battery cells 22, and the multiple battery cells 22 can be connected in series, parallel, or series-parallel, where being connected in series-parallel means that the multiple battery cells 22 are connected in both series and parallel. The multiple battery cells 22 can be directly connected in series, parallel, or series-parallel, and then an entirety formed by the multiple battery cells 22 is accommodated in the battery box 21. Certainly, the battery 20 may alternatively be formed by first connecting multiple battery cells 22 in series, parallel, or series-parallel to form battery modules, and then connecting multiple battery modules in series, parallel, or series-parallel to form an entirety which is accommodated in the battery box 21. The battery 20 may further include other functional components. For example, the battery 20 may further include a busbar component configured to achieve electrical connection among the multiple battery cells 22.

Each battery cell 22 may be a secondary battery or a primary battery, where a secondary battery refers to a battery cell 22 that can be reused by activating active materials through charging after discharge, and a primary battery refers to a battery cell 22 that cannot be reused by activating active materials through charging after the electrical energy is exhausted. The battery cell 22 may alternatively be a lithium-ion battery, a sodium-ion battery, a sodium-lithium-ion battery, a lithium metal battery, a sodium metal battery, a lithium-sulfur battery, a magnesium-ion battery, a nickel-hydrogen battery, a nickel-cadmium battery, a lead-acid battery, or the like, without limitation thereto. The battery cell 22 may be a cylindrical battery cell, a prismatic battery cell, a pouch battery cell, or a battery cell 22 of other shapes, where the prismatic battery cell includes a square-shell battery cell, a blade-shaped battery cell, and a polygonal prismatic battery. The polygonal prismatic battery is, for example, a hexagonal prismatic battery, without particular limitation in the present application.

The electric drive apparatus 10 is configured to convert electrical energy provided by the battery 20 into mechanical energy and output the mechanical energy to the wheels of the vehicle 1000 to drive the vehicle 1000 to travel. The electric drive apparatus 10 is mounted in the engine compartment. Specifically, when the vehicle 1000 is a front-wheel drive vehicle, the electric drive apparatus 10 is mounted in the front engine compartment and configured to output the mechanical energy to front wheels of the vehicle 1000 to drive the vehicle 1000 to travel. When the vehicle 1000 is a rear-wheel drive vehicle, the electric drive apparatus 10 is mounted in the rear engine compartment and configured to output the mechanical energy to rear wheels of the vehicle 1000 to drive the vehicle 1000 to travel. When the vehicle 1000 is a four-wheel drive vehicle, there are two electric drive apparatuses 10, where one electric drive apparatus 10 is mounted in the front engine compartment and configured to output the mechanical energy to the front wheels of the vehicle 1000, and the other electric drive apparatus 10 is mounted in the rear engine compartment and configured to output the mechanical energy to the rear wheels of the vehicle 1000 to drive the vehicle 1000 to travel.

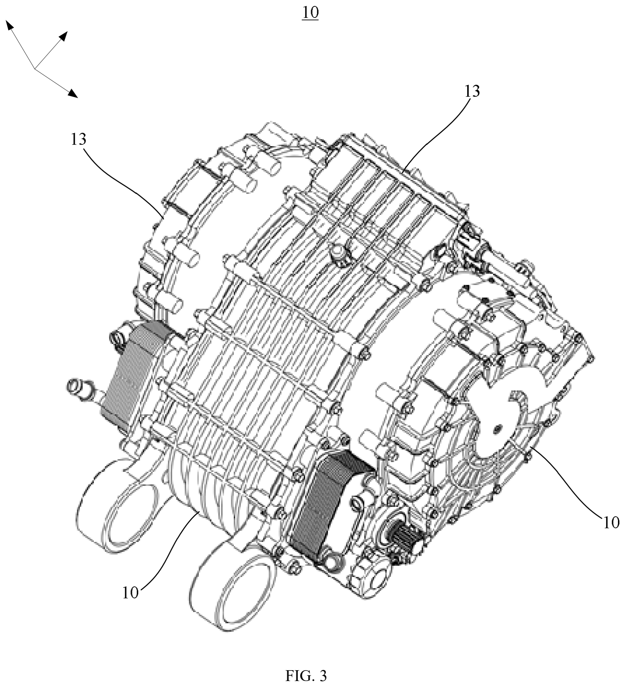

Referring to FIG. 3, the electric drive apparatus 10 includes a first motor 12, a second motor 13, and a motor controller 11, where the first motor 12 and the second motor 13 are configured to convert electrical energy provided by the battery 20 into mechanical energy. During operation of the electric drive apparatus 10, a rotation speed of the first motor 12 and a rotation speed of the second motor 13 may be the same, or the rotation speed of the first motor 12 and the rotation speed of the second motor 13 may be different. Rotation shafts of the first motor 12 and the second motor 13 are parallel to each other. The first motor 12 may be coaxially disposed with the second motor 13, that is, a central axis of the first motor 12 coincides with a central axis of the second motor 13. Alternatively, the first motor 12 may be non-coaxially disposed with the second motor 13, that is, the central axis of the first motor 12 and the central axis of the second motor 13 are spaced apart along any direction perpendicular to the central axis of the first motor 12. A "central axis" of a motor refers to an axial center line of a rotation shaft (or "a rotor shaft") of the motor. Optionally, the first motor 12 may be an axial flux motor, a radial flux motor, a servo motor, a brushed motor, a brushless motor, or the like, without specific limitation herein. Similarly, the second motor 13 may be an axial flux motor, a radial flux motor, a servo motor, a brushed motor, a brushless motor, or the like, without specific limitation herein.

The motor controller 11 is configured to convert direct current output by the battery 20 into alternating current and deliver the alternating current to the first motor 12 and the second motor 13, and is also configured to control the operation of the first motor 12 and the second motor 13. For example, the motor controller 11 is configured to control start-stop, rotation speed, torque, and the like of the first motor 12 and the second motor 13. Certainly, alternating current generated by rotation of the first motor 12 and the second motor 13 can also be rectified into direct current and delivered to the battery 20, that is, the commonly mentioned kinetic energy recovery function. In other words, the first motor 12, the second motor 13, and the battery 20 are electrically connected to the motor controller 11. The direct current output by the battery 20 can be delivered to the motor controller 11 through an electrical connection path between the battery 20 and the motor controller 11. After the motor controller 11 converts the direct current into alternating current, the alternating current can be delivered to the first motor 12 and the second motor 13 through an electrical connection path between the motor controller 11 and the first motor 12 and an electrical connection path between the motor controller 11 and the second motor 13 so as to drive the first motor 12 and the second motor 13 to operate. In addition, control signals of the motor controller 11 can be transmitted to the first motor 12 and the second motor 13 through the electrical connection path between the motor controller 11 and the first motor 12 and the electrical connection path between the motor controller 11 and the second motor 13, operation state signals of the first motor 12 can be transmitted to the motor controller 11 through the electrical connection path between the motor controller 11 and the first motor 12, and operation state signals of the second motor 13 can be transmitted to the motor controller 11 through the electrical connection path between the motor controller 11 and the second motor 13, so as to achieve control of the operation of the first motor 12 and the second motor 13 by the motor controller 11.

The electric drive apparatus 10 may further include a transmission mechanism 14, where the transmission mechanism 14 is configured to transmit the mechanical energy to the wheels of the vehicle 1000 in a manner of changing the rotation speed and torque of the first motor 12 and the rotation speed and torque of the second motor 13. For example, the transmission mechanism 14 transmits the mechanical energy to the wheels of the vehicle 1000 in a manner of reducing the rotation speed of the first motor 12 and the rotation speed of the second motor 13 and increasing the torque of the first motor 12 and the torque of the second motor 13. For another example, the transmission mechanism 14 transmits the mechanical energy to the wheels of the vehicle 1000 in a manner of increasing the rotation speed of the first motor 12 and the rotation speed of the second motor 13 and reducing the torque of the first motor 12 and the torque of the second motor 13. Additionally, the transmission mechanism 14 can also be configured to change a direction of an output shaft of the electric drive apparatus 10 relative to an output shaft of the first motor 12 and an output shaft of the second motor 13. For example, a bevel gear or a worm gear structure is configured to connect the output shaft of the first motor 12 and the output shaft of the second motor 13 and further change a direction of torque output. Optionally, the transmission mechanism 14 may be but is not limited to a gear-shaft transmission mechanism, a worm transmission mechanism, a planetary gear transmission mechanism, a continuously variable transmission mechanism, or the like, without specific limitation herein.

The electric drive apparatus 10 provided by the embodiments of the present application will be described below with reference to the drawings.

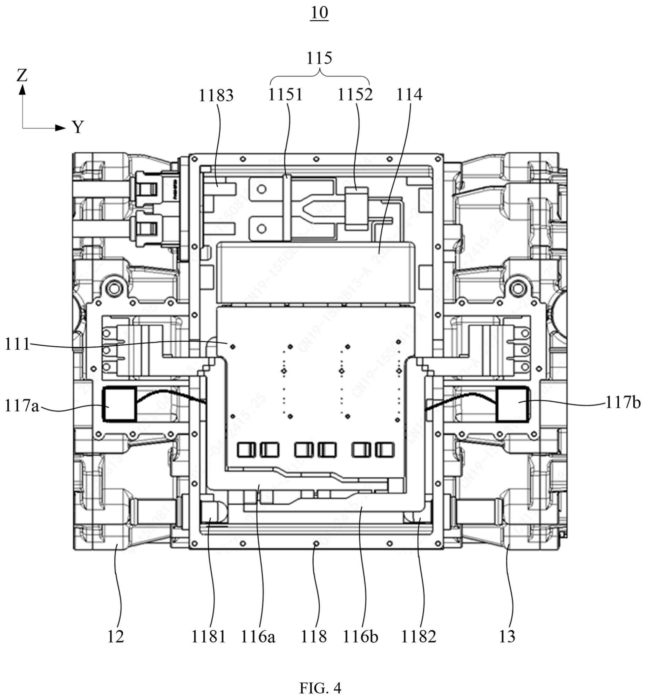

According to a first aspect, referring to FIGs. 4 to 8 together, an embodiment of the present application provides a motor controller 11 including a first control assembly 111, a second control assembly 112, and a cooling assembly 113. The first control assembly 111 is electrically connected to the first motor 12. The second control assembly 112 is electrically connected to the second motor 13. The cooling assembly 113 is configured to cool the first control assembly 111 and the second control assembly 112. The first control assembly 111, the cooling assembly 113, and the second control assembly 112 are sequentially stacked.

The first control assembly 111 is configured to convert the direct current output by the battery 20 into alternating current and deliver the alternating current to the first motor 12, and is also configured to control the operation of the first motor 12. For example, the first control assembly 111 is configured to control start-stop, rotation speed, torque, and the like of the first motor 12. In other words, the first motor 12 and the battery 20 are electrically connected to the first control assembly 111. For example, the motor controller 11 further includes a first electrical connection member 116a and a first sampling harness 117a. One end of the first electrical connection member 116a is connected to a first alternating current output terminal (not shown in the figure) of the first control assembly 111, and the other end of the first electrical connection member 116a is connected to an alternating current input terminal (not shown in the figure) of the first motor 12. The direct current output by the battery 20 can be delivered to the first control assembly 111 through an electrical connection path between the battery 20 and the first control assembly 111. After the first control assembly 111 converts the direct current into alternating current, the alternating current can be delivered to the first motor 12 through the first electrical connection member 116a so as to drive the first motor 12 to operate. In addition, one end of the first sampling harness 117a is connected to a first sampling terminal (not shown in the figure) of the first control assembly 111, and the other end of the first sampling harness 117a is connected to a sampling terminal (not shown in the figure) of the first motor 12. Control signals of the first control assembly 111 can be transmitted to the first motor 12 through the first sampling harness 117a, and operation state signals of the first motor 12 can also be transmitted to the first control assembly 111 through the first sampling harness 117a, so as to achieve control of the operation of the first motor 12 by the first control assembly 111. Optionally, a material of the first electrical connection member 116a may be but is not limited to copper, aluminum, iron, or the like, without specific limitation herein.

The second control assembly 112 is configured to convert the direct current output by the battery 20 into alternating current and deliver the alternating current to the second motor 13, and is also configured to control the operation of the second motor 13. For example, the second control assembly 112 is configured to control start-stop, rotation speed, torque, and the like of the second motor 13. In other words, the second motor 13 and the battery 20 are electrically connected to the second control assembly 112. For example, the motor controller 11 further includes a second electrical connection member 116b and a second sampling harness 117b. One end of the second electrical connection member 116b is connected to a second alternating current output terminal (not shown in the figure) of the second control assembly 112, and the other end of the second electrical connection member 116b is connected to an alternating current input terminal (not shown in the figure) of the second motor 13. The direct current output by the battery 20 can be delivered to the second control assembly 112 through an electrical connection path between the battery 20 and the second control assembly 112. After the second control assembly 112 converts the direct current into alternating current, the alternating current can be delivered to the second motor 13 through the second electrical connection member 116b so as to drive the second motor 13 to operate. In addition, one end of the second sampling harness 117b is connected to a second sampling terminal (not shown in the figure) of the second control assembly 112, and the other end of the second sampling harness 117b is connected to a sampling terminal (not shown in the figure) of the second motor 13. Control signals of the second control assembly 112 can be transmitted to the second motor 13 through the second sampling harness 117b, and operation state signals of the second motor 13 can also be transmitted to the second control assembly 112 through the second sampling harness 117b, so as to achieve control of the operation of the second motor 13 by the second control assembly 112. Optionally, a material of the second electrical connection member 116b may be but is not limited to copper, aluminum, iron, or the like, without specific limitation herein.

The cooling assembly 113 is a component configured to cool the first control assembly 111 and the second control assembly 112. Understandably, a heat-generating portion of the first control assembly 111 and a heat-generating portion of the second control assembly 112 are in contact with the cooling assembly 113, and heat generated by the heat-generating portion of the first control assembly 111 and heat generated by the heat-generating portion of the second control assembly 112 are transferred to the cooling assembly 113, so as to achieve the purpose of cooling the first control assembly 111 and the second control assembly 112. Optionally, the cooling assembly 113 may be but is not limited to a liquid cooling assembly, an air cooling assembly, a metal conduction cooling assembly, or the like, without specific limitation herein.

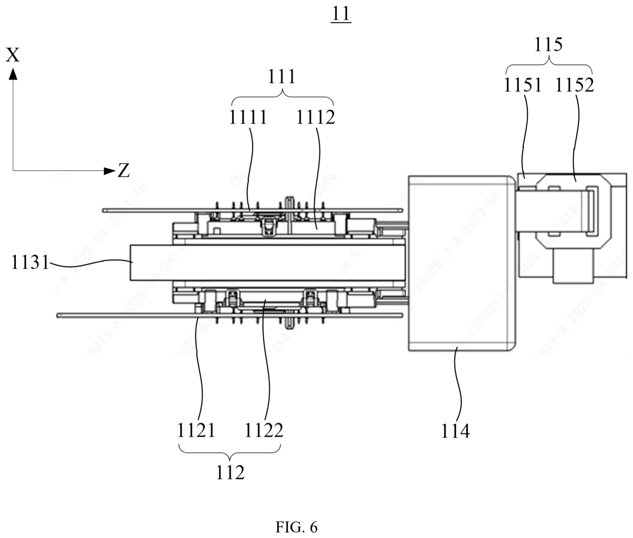

In some embodiments, the first control assembly 111, the second control assembly 112, and the cooling assembly 113 are generally in plate-like structures. The first control assembly 111, the cooling assembly 113, and the second control assembly 112 being sequentially stacked means that: plate surfaces of the first control assembly 111, the second control assembly 112, and the cooling assembly 113 are generally parallel to each other, with any plane parallel to the plate surface of the first control assembly 111 as a reference plane. In a direction perpendicular to the plate surface of the first control assembly 111 (for example, a direction X shown in FIG. 6), a projection of the first control assembly 111 on the reference plane and a projection of the second control assembly 112 on the reference plane at least partially overlap with a projection of the cooling assembly 113 on the reference plane.

In the motor controller 11 provided by this embodiment of the present application, by sequentially stacking the first control assembly 111, the cooling assembly 113, and the second control assembly 112, with the first control assembly 111 and the second control assembly 112 located on both sides of the cooling assembly 113, the first control assembly 111 and the second control assembly 112 can share one cooling assembly 113, effectively reducing the number of components of the motor controller 11. Moreover, compared with a method of arranging multiple control assemblies in a dispersed manner, the method of sequentially stacking the first control assembly 111, the cooling assembly 113, and the second control assembly 112 can make the structure of the motor controller 11 more compact, thereby effectively reducing the volume of the motor controller 11, and further effectively reducing the volume of an electric drive apparatus 10 using the motor controller 11.

In some embodiments of the present application, referring to FIG. 4, the motor controller 11 is disposed between the first motor 12 and the second motor 13.

Understandably, the first motor 12 and the second motor 13 are oppositely disposed along a direction parallel to a central axis of the first motor 12 and spaced to form an arrangement space. The motor controller 11 is disposed in the arrangement space. The motor controller 11 can be entirely disposed in the arrangement space or partially disposed in the arrangement space. In these embodiments, the first control assembly 111, the second control assembly 112, the cooling assembly 113, and a capacitor 114 and a direct current input assembly 115 described below are disposed in the arrangement space.

By adopting the above technical solution, the space between the first motor 12 and the second motor 13 can be effectively utilized, thereby further reducing the volume of the electric drive apparatus 10.

In some embodiments of the present application, referring to FIGs. 3 and 6 together, the first control assembly 111, the cooling assembly 113, and the second control assembly 112 are sequentially stacked along a first direction, where the first direction is perpendicular to the central axis of the first motor 12 and a central axis of the second motor 13. For example, the first direction is the direction X shown in FIGs. 3 and 6.

By adopting the above technical solution, a thickness direction (for example, the direction X shown in FIGs. 3 and 6) of an entirety formed by stacking the first control assembly 111, the cooling assembly 113, and the second control assembly 112 corresponds to a depth direction of the space between the first motor 12 and the second motor 13, while a width direction (for example, a direction Y shown in FIGs. 3 to 5) or a length direction (for example, a direction Z shown in FIGs. 3 to 6) of the entirety formed by stacking the first control assembly 111, the cooling assembly 113, and the second control assembly 112 corresponds to a width direction of the space between the first motor 12 and the second motor 13. This can more effectively utilize the space between the first motor 12 and the second motor 13, thereby further reducing the volume of the electric drive apparatus 10.

In some embodiments of the present application, referring to FIGs. 4 to 6 together, the motor controller 11 further includes a capacitor 114 electrically connected to the first control assembly 111 and the second control assembly 112, and a direct current input assembly 115 electrically connected to the capacitor 114, where the first control assembly 111, the second control assembly 112, and the cooling assembly 113 are disposed on one side of the capacitor 114. The direct current input assembly 115 is disposed on a side of the capacitor 114 facing away from the first control assembly 111, the second control assembly 112, and the cooling assembly 113.

The capacitor 114 is configured to smooth the voltage of the direct current input assembly 115, so that voltage fluctuations on the direct current input assembly 115 are kept within an allowable range, and adverse effects on the first control assembly 111 and the second control assembly 112 caused by voltage overshoot and transient overvoltage from the direct current input assembly 115 are reduced. In some embodiments, the capacitor 114 has a first connection terminal (not shown in the figure) and a second connection terminal (not shown in the figure). The direct current input assembly 115 is electrically connected to the first connection terminal. The first control assembly 111 and the second control assembly 112 are electrically connected to the second connection terminal. Optionally, the capacitor 114 may be but is not limited to a film capacitor, an electrolytic capacitor, an electric double-layer capacitor, or the like, without specific limitation herein.

The direct current input assembly 115 is configured to be electrically connected to the battery 20 so as to deliver direct current provided by the battery 20 to the capacitor 114. Specifically, the direct current input assembly 115 may include a third electrical connection member 1151. One end of the third electrical connection member 1151 is electrically connected to the battery 20, and the other end of the third electrical connection member 1151 is connected to the first connection terminal of the capacitor 114. Optionally, a material of the third electrical connection member 1151 may be but is not limited to copper, aluminum, iron, or the like, without specific limitation herein. The direct current input assembly 115 may further include an EMC (Electromagnetic Compatibility, electromagnetic compatibility) filter 1152. The EMC filter 1152 is disposed on the third electrical connection member 1151 and is configured to reduce or eliminate interference effects on the first control assembly 111, the second control assembly 112, and the capacitor 114 caused by electromagnetic waves generated after the third electrical connection member 1151 is energized. Optionally, the EMC filter 1152 may be but is not limited to a ferrite tube, a ferrite magnetic ring, a magnetic ring choke coil, or the like, without specific limitation herein.

The first control assembly 111, the second control assembly 112, and the cooling assembly 113 are disposed on one side of the capacitor 114. The direct current input assembly 115 is disposed on the side of the capacitor 114 facing away from the first control assembly 111, the second control assembly 112, and the cooling assembly 113. In other words, the capacitor 114 is disposed between the entirety formed by stacking the first control assembly 111, the cooling assembly 113, and the second control assembly 112 and the direct current input assembly 115.

By adopting the above technical solution, the entirety formed by stacking the first control assembly 111, the cooling assembly 113, and the second control assembly 112, the capacitor 114, and the direct current input assembly 115 are sequentially arranged along one direction, making the structure of the motor controller 11 more compact, thereby further reducing the volume of the motor controller 11 and further reducing the volume of the electric drive apparatus 10. In addition, the capacitor 114 is disposed between the entirety formed by stacking the first control assembly 111, the cooling assembly 113, and the second control assembly 112 and the direct current input assembly 115, so that the magnetic interference of the direct current input assembly 115 on the first control assembly 111 and the second control assembly 112 is effectively alleviated, thereby effectively improving the reliability of the motor controller 11.

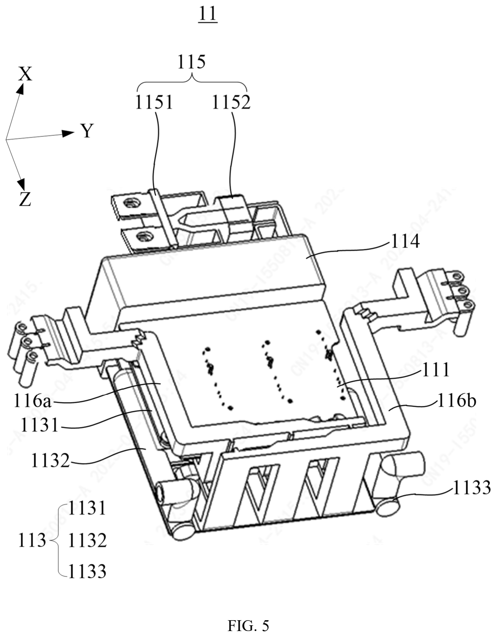

In some embodiments of the present application, referring to FIGs. 3 to 6 together, the first control assembly 111, the second control assembly 112, and the cooling assembly 113 are disposed on one side of the capacitor 114 along a second direction. The direct current input assembly 115 is disposed on the other side of the capacitor 114 along the second direction. The second direction is a direction perpendicular to the first direction, the central axis of the first motor 12, and the central axis of the second motor 13. For example, the second direction is the direction Z shown in FIGs. 4 and 5.

In other words, the entirety formed by stacking the first control assembly 111, the cooling assembly 113, and the second control assembly 112, the capacitor 114, and the direct current input assembly 115 are sequentially disposed along the second direction, making the motor controller 11 generally in a cuboid structure, thereby making the structure of the motor controller 11 more compact and further reducing the volume of the motor controller 11. In addition, since the first direction is perpendicular to the central axis of the first motor 12 and the central axis of the second motor 13, and the second direction is the direction perpendicular to the first direction, the central axis of the first motor 12, and the central axis of the second motor 13, a width direction of the motor controller 11 (for example, the direction Y shown in FIGs. 3 to 5) corresponds to the width direction of the space between the first motor 12 and the second motor 13. This can more effectively utilize the space between the first motor 12 and the second motor 13, thereby further reducing the volume of the electric drive apparatus 10.

In some embodiments of the present application, referring to FIGs. 4 and 5 together, the first alternating current output terminal is disposed on a side of the first control assembly 111 facing away from the capacitor 114. One end of the first electrical connection member 116a is electrically connected to the first alternating current output terminal, and the other end of the first electrical connection member 116a extends from the first alternating current output terminal to a side of the first control assembly 111 facing the first motor 12 and is electrically connected to the alternating current input terminal of the first motor 12.

By adopting the above technical solution, the layout design of a direct current-alternating current conversion circuit of a first control module 1111 is facilitated, and an alternating current transmission path between the first control assembly 111 and the first motor 12 can be effectively shortened, thereby further reducing the volume of the motor controller 11.

In some embodiments of the present application, referring to FIGs. 4 and 5 together, the second alternating current output terminal is disposed on a side of the second control assembly 112 facing away from the capacitor 114. One end of the second electrical connection member 116b is electrically connected to the second alternating current output terminal, and the other end of the second electrical connection member 116b extends from the second alternating current output terminal to a side of the second control assembly 112 facing the second motor 13 and is electrically connected to the alternating current input terminal of the second motor 13.

By adopting the above technical solution, the layout design of a direct current-alternating current conversion circuit of a second control module 1121 is facilitated, and an alternating current transmission path between the second control assembly 112 and the second motor 13 can be effectively shortened, thereby further reducing the volume of the motor controller 11.

In some embodiments of the present application, referring to FIGs. 4 and 5 together, the first alternating current output terminal is disposed on the side of the first control assembly 111 facing away from the capacitor 114. One end of the first electrical connection member 116a is electrically connected to the first alternating current output terminal, and the other end of the first electrical connection member 116a extends from the first alternating current output terminal to the side of the first control assembly 111 facing the first motor 12 and is electrically connected to the alternating current input terminal of the first motor 12. The second alternating current output terminal is disposed on the side of the second control assembly 112 facing away from the capacitor 114. One end of the second electrical connection member 116b is electrically connected to the second alternating current output terminal, and the other end of the second electrical connection member 116b extends from the second alternating current output terminal to the side of the second control assembly 112 facing the second motor 13 and is electrically connected to the alternating current input terminal of the second motor 13.

By adopting the above technical solution, the layout design of the direct current-alternating current conversion circuit of the first control module 1111 and the direct current-alternating current conversion circuit of the second control module 1121 is facilitated. In addition, the alternating current transmission path between the first control assembly 111 and the first motor 12 and the alternating current transmission path between the second control assembly 112 and the second motor 13 can be effectively shortened, thereby further reducing the volume of the motor controller 11.

In some embodiments of the present application, referring to FIG. 4, the first sampling terminal is disposed on a side of the first control assembly 111 facing the first motor 12.

By adopting the above technical solution, a sampling path between the first control assembly 111 and the first motor 12 is effectively shortened, thereby further reducing the volume of the motor controller 11.

In some embodiments of the present application, referring to FIG. 4, the second sampling terminal is disposed on a side of the second control assembly 112 facing the second motor 13.

By adopting the above technical solution, a sampling path between the second control assembly 112 and the second motor 13 is effectively shortened, thereby further reducing the volume of the motor controller 11.

In some embodiments of the present application, referring to FIG. 4, the first sampling terminal is disposed on the side of the first control assembly 111 facing the first motor 12. The second sampling terminal is disposed on the side of the second control assembly 112 facing the second motor 13.

By adopting the above technical solution, the sampling path between the first control assembly 111 and the first motor 12 and the sampling path between the second control assembly 112 and the second motor 13 are effectively shortened, thereby further reducing the volume of the motor controller 11.

In some embodiments of the present application, referring to FIG. 4, the motor controller 11 further includes a box 118, where the first control assembly 111, the second control assembly 112, the cooling assembly 113, the capacitor 114, and the direct current input assembly 115 are accommodated in the box 118.

The box 118 is a component configured to provide an internal installation environment for the motor controller 11. The box 118 may be an integrally formed member or an assembled member formed by assembling multiple portions. A material of the box 118 may be but is not limited to copper, iron, aluminum, stainless steel, aluminum alloy, or the like, without specific limitation herein.

In some embodiments, the motor controller 11 may further include a cover (not shown in the figure), where the cover covers an opening side of the box 118 to isolate the internal installation environment from the external environment. The cover and the box 118 can be connected integrally. For example, after the cover covers the box 118, the cover and the box 118 are welded integrally, or the cover can be detachably connected to the box 118. For example, the cover and the box 118 are connected through fasteners such as bolts and rivets. A material of the cover may be but is not limited to copper, iron, aluminum, stainless steel, aluminum alloy, or the like, without specific limitation herein.

By adopting the above technical solution, the first control assembly 111, the second control assembly 112, the cooling assembly 113, the capacitor 114, and the direct current input assembly 115 are effectively protected.

In some embodiments of the present application, the first control assembly 111, the second control assembly 112, the cooling assembly 113, the capacitor 114, and the direct current input assembly 115 are connected and integrated into an entirety.

A connection method of the first control assembly 111, the second control assembly 112, the cooling assembly 113, the capacitor 114, and the direct current input assembly 115 may be but is not limited to fastening connection, bonding, welding, or the like. For example, the first control assembly 111, the cooling assembly 113, and the second control assembly 112 are sequentially stacked and then connected into an entirety using fasteners, and then the entirety, the capacitor 114, and the direct current input assembly 115 are sequentially connected into an entirety using fasteners.

By adopting the above technical solution, the first control assembly 111, the second control assembly 112, the cooling assembly 113, the capacitor 114, and the direct current input assembly 115 are connected into an entirety and then assembled into the box 118, thereby effectively improving the assembly efficiency of the motor controller 11.

In some embodiments of the present application, referring to FIG. 4, the first electrical connection member 116a is detachably connected to the alternating current input terminal of the first motor 12. The second electrical connection member 116b is detachably connected to the alternating current input terminal of the second motor 13. An inner wall of the box 118 is provided with a liquid inlet connector 1181, a liquid outlet connector 1182, and a direct current input terminal 1183. The cooling assembly 113 includes a liquid inlet pipe 1132 detachably connected to the liquid inlet connector 1181 and a liquid outlet pipe 1133 detachably connected to the liquid outlet connector 1182. The third electrical connection member 1151 is detachably connected to the direct current input terminal 1183.

In these embodiments, the cooling assembly 113 is a liquid cooling assembly. The cooling assembly 113 further includes a liquid cooling plate 1131. A cooling flow channel (not shown in the figure) is provided inside the liquid cooling plate 1131. One end of the liquid inlet pipe 1132 is in communication with an inlet of the cooling flow channel, and the other end of the liquid inlet pipe 1132 is detachably connected to the liquid inlet connector 1181. One end of the liquid outlet pipe 1133 is in communication with an outlet of the cooling flow channel, and the other end of the liquid outlet pipe 1133 is detachably connected to the liquid outlet connector 1182. Understandably, the liquid inlet connector 1181 is connected to a cooling medium container. The liquid outlet connector 1182 may be connected to the cooling medium container to allow a cooling medium to flow back into the cooling medium container, or the liquid outlet connector 1182 may be connected to other external containers to collect the cooling medium. The cooling medium sequentially flows from the cooling medium container to the liquid inlet connector 1181, the liquid inlet pipe 1132, the cooling flow channel, the liquid outlet pipe 1133, and the liquid outlet connector 1182 to take away heat generated by the first control assembly 111 and heat generated by the second control assembly 112, thereby achieving the purpose of cooling the first control assembly 111 and the second control assembly 112.

The direct current input terminal 1183 is a portion configured to electrically connect the motor controller 11 to the battery 20. The direct current output by the battery 20 is input into the motor controller 11 through the direct current input terminal 1183 and sequentially delivered to the first control assembly 111 and the second control assembly 112 through the third electrical connection member 1151 and the capacitor 114.

Detachable connection means that after two components are connected, the two components can be separated again without damaging the components. The detachable connection method may be but is not limited to fastening connection, snap connection, plug connection, or the like, without specific limitation herein. For example, the first electrical connection member 116a and the alternating current input terminal of the first motor 12 are connected through fasteners such as bolts and screws. When it is necessary to separate the first electrical connection member 116a from the alternating current input terminal of the first motor 12, the fasteners can be loosened, and then the first electrical connection member 116a can be taken out from the alternating current input terminal of the first motor 12.

By adopting the above technical solution, when maintenance of the motor controller 11 is required, the first electrical connection member 116a can be detached from the alternating current input terminal of the first motor 12, the second electrical connection member 116b can be detached from the alternating current input terminal of the second motor 13, the liquid inlet pipe 1132 can be detached from the liquid inlet connector 1181, the liquid outlet pipe 1133 can be detached from the liquid outlet connector 1182, and the third electrical connection member 1151 can be detached from the direct current input terminal 1183; and then the entirety formed by connecting the first control assembly 111, the second control assembly 112, the cooling assembly 113, the capacitor 114, and the direct current input assembly 115 can be taken out from the box 118, so as to facilitate maintenance of one or more of the first control assembly 111, the second control assembly 112, the cooling assembly 113, the capacitor 114, and the direct current input assembly 115.

In some embodiments of the present application, referring to FIG. 6, the first control assembly 111 includes a first power module 1112 and a first control module 1111. The second control assembly 112 includes a second power module 1122 and a second control module 1121. The first control module 1111, the first power module 1112, the cooling assembly 113, the second power module 1122, and the second control module 1121 are sequentially stacked.

The first control module 1111 is a core control component of the motor controller 11 and is configured to control the operation of the first motor 12.

The first power module 1112 is a component configured to convert the direct current provided by the battery 20 into alternating current for driving the first motor 12 to operate. Optionally, the first power module 1112 may be but is not limited to a silicon carbide power module, a MOSFET (Metal-Oxide-Semiconductor Field-Effect Transistor, metal-oxide-semiconductor field-effect transistor) power module, an IGBT (Insulated Gate Bipolar Transistor, insulated gate bipolar transistor) power module, or the like, without specific limitation herein.

The second control module 1121 is a core control component of the motor controller 11 and is configured to control the operation of the second motor 13.

The second power module 1122 is a component configured to convert the direct current provided by the battery 20 into alternating current for driving the second motor 13 to operate. Optionally, the second power module 1122 may be but is not limited to a silicon carbide power module, a MOSFET (Metal-Oxide-Semiconductor Field-Effect Transistor, metal-oxide-semiconductor field-effect transistor) power module, an IGBT (Insulated Gate Bipolar Transistor, insulated gate bipolar transistor) power module, or the like, without specific limitation herein.

By adopting the above technical solution, the structure of the motor controller 11 can be made more compact, effectively reducing the volume of the motor controller 11, thereby effectively reducing the volume of the electric drive apparatus 10 using the motor controller 11.

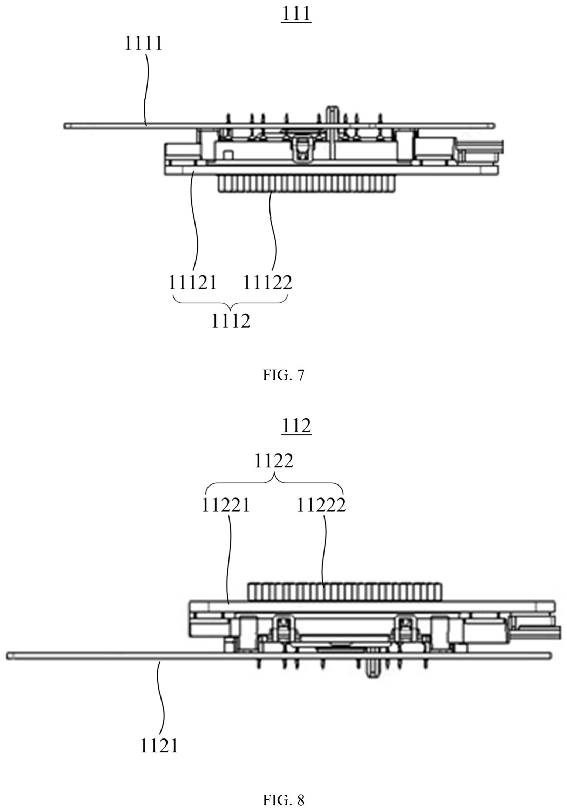

In some embodiments of the present application, referring to FIGs. 6 and 7 together, the cooling assembly 113 includes a liquid cooling plate 1131. A cooling flow channel is provided inside the liquid cooling plate 1131. The first power module 1112 includes a first power body 11121 and a first heat conduction member 11122. The first heat conduction member 11122 is disposed on a side of the first power body 11121 facing the liquid cooling plate 1131 and inserted into the cooling flow channel.

The first power body 11121 is a main component of the first power module 1112 and is configured to convert the direct current provided by the battery 20 into alternating current for driving the first motor 12 to operate.

The first heat conduction member 11122 is a heat dissipation component of the first power module 1112. The first heat conduction member 11122 is disposed on a heat-generating portion of the first power body 11121 to transfer heat generated by the heat-generating portion of the first power body 11121 to the liquid cooling plate 1131. Understandably, the first heat conduction member 11122 is made of a thermally conductive material. The thermally conductive material may be but is not limited to aluminum, aluminum alloy, copper, iron, steel, or the like, without specific limitation herein. The first heat conduction member 11122 being inserted into the cooling flow channel means that at least a portion of the first heat conduction member 11122 is placed in the cooling flow channel and is in contact with a cooling medium in the cooling flow channel, so that heat on the first heat conduction member 11122 can be directly transferred to the cooling medium.

In some embodiments, there may be multiple first power bodies 11121. The multiple first power bodies 11121 are arranged along a direction parallel to a plate surface of the liquid cooling plate 1131. Correspondingly, there are also multiple first heat conduction members 11122. The multiple first heat conduction members 11122 are disposed in one-to-one correspondence with the multiple first power bodies 11121.

In some embodiments, the first heat conduction member 11122 includes multiple first heat conduction portions. The multiple first heat conduction portions are arranged in an array structure on the heat-generating portion of the first power body 11121 and inserted into the cooling flow channel, so as to increase a heat conduction area of the first heat conduction member 11122, thereby effectively improving the cooling efficiency of the first control assembly 111.

In some embodiments, to reduce the risk of leakage of the cooling medium, a first sealing structure is disposed between the first heat conduction member 11122 and the liquid cooling plate 1131.

By adopting the above technical solution, heat generated by operation of the first power body 11121 can be transferred to the cooling medium in the cooling flow channel through the first heat conduction member 11122, thereby effectively improving the cooling efficiency of the cooling assembly 113 on the first power module 1112. In addition, the first heat conduction member 11122 is inserted into the cooling flow channel, the thickness of the entirety formed by stacking the first control assembly 111, the cooling assembly 113, and the second control assembly 112 can be effectively reduced, thereby making the structure of the motor controller 11 more compact and further reducing the volume of the motor controller 11.

In some embodiments of the present application, referring to FIGs. 6 and 8 together, the second power module 1122 includes a second power body 11221 and a second heat conduction member 11222. The second heat conduction member 11222 is disposed on a side of the second power body 11221 facing the liquid cooling plate 1131 and inserted into the cooling flow channel.

The second power body 11221 is a main component of the second power module 1122 and is configured to convert the direct current provided by the battery 20 into alternating current for driving the second motor 13 to operate.

The second heat conduction member 11222 is a heat dissipation component of the second power module 1122. The second heat conduction member 11222 is disposed on a heat-generating portion of the second power body 11221 to transfer heat generated by the heat-generating portion of the second power body 11221 to the liquid cooling plate 1131. Understandably, the second heat conduction member 11222 is made of a thermally conductive material. The thermally conductive material may be but is not limited to aluminum, aluminum alloy, copper, iron, steel, or the like, without specific limitation herein. The second heat conduction member 11222 being inserted into the cooling flow channel means that at least a portion of the second heat conduction member 11222 is placed in the cooling flow channel and is in contact with the cooling medium in the cooling flow channel, so that heat on the second heat conduction member 11222 can be directly transferred to the cooling medium.

In some embodiments, there may be multiple second power bodies 11221. The multiple second power bodies 11221 are arranged along the direction parallel to the plate surface of the liquid cooling plate 1131. Correspondingly, there are also multiple second heat conduction members 11222. The multiple second heat conduction members 11222 are disposed in one-to-one correspondence with the multiple second power bodies 11221.

In some embodiments, the second heat conduction member 11222 includes multiple second heat conduction portions. The multiple second heat conduction portions are arranged in an array structure on the heat-generating portion of the second power body 11221 and inserted into the cooling flow channel, so as to increase a heat conduction area of the second heat conduction member 11222, thereby effectively improving the cooling efficiency of the second control assembly 112.

In some embodiments, to reduce the risk of leakage of the cooling medium, a second sealing structure is disposed between the second heat conduction member 11222 and the liquid cooling plate 1131.

By adopting the above technical solution, heat generated by operation of the second power body 11221 can be transferred to the cooling medium in the cooling flow channel through the second heat conduction member 11222, thereby effectively improving the cooling efficiency of the cooling assembly 113 on the second power module 1122. In addition, the second heat conduction member 11222 is inserted into the cooling flow channel, so that the thickness of the entirety formed by stacking the first control assembly 111, the cooling assembly 113, and the second control assembly 112 can be effectively reduced, thereby making the structure of the motor controller 11 more compact and further reducing the volume of the motor controller 11.

In some embodiments of the present application, referring to FIGs. 6 and 8 together, the cooling assembly 113 includes the liquid cooling plate 1131. The cooling flow channel is provided inside the liquid cooling plate 1131. The first power module 1112 includes the first power body 11121 and the first heat conduction member 11122. The first heat conduction member 11122 is disposed on the side of the first power body 11121 facing the liquid cooling plate 1131 and inserted into the cooling flow channel. The second power module 1122 includes the second power body 11221 and the second heat conduction member 11222. The second heat conduction member 11222 is disposed on the side of the second power body 11221 facing the liquid cooling plate 1131 and inserted into the cooling flow channel.

The first heat conduction member 11122 and the second heat conduction member 11222 are inserted into the cooling flow channel, so that the thickness of the entirety formed by stacking the first control assembly 111, the cooling assembly 113, and the second control assembly 112 can be effectively reduced, thereby making the structure of the motor controller 11 more compact and further reducing the volume of the motor controller 11.

In some embodiments of the present application, the first control module 1111 includes a first circuit board, where the first circuit board is provided with a first drive circuit (not shown in the figure) and a first control circuit (not shown in the figure).

The first circuit board is a carrier for various electronic components in the first control module 1111 and is configured to provide electrical connection lines among the various electronic components.

The first drive circuit is a component integration structure configured to control, drive, and protect normal operation of the first power module 1112. For example, the first drive circuit may include an IGBT high-voltage device drive unit, a storage chip unit, a power supply unit, and the like.

The first control circuit is a component integration structure configured to control the operation of the first motor 12. For example, the first control circuit may include a main chip unit, a power chip unit, a communication unit, a decoder unit, a storage chip unit, a temperature acquisition unit, a signal amplification unit, a PWM output unit, and the like.

By integrating the first drive circuit and the first control circuit on the first circuit board, the integration degree of the motor controller 11 is effectively improved, thereby further reducing the volume of the motor controller 11.

In some embodiments of the present application, the second control module 1121 includes a second circuit board, where the second circuit board is provided with a second drive circuit (not shown in the figure) and a second control circuit (not shown in the figure).

The second circuit board is a carrier for various electronic components in the second control module 1121 and is configured to provide electrical connection lines among the various electronic components.

The second drive circuit is a component integration structure configured to control, drive, and protect normal operation of the second power module 1122. For example, the second drive circuit may include an IGBT high-voltage device drive unit, a storage chip unit, a power supply unit, and the like.

The second control circuit is a component integration structure configured to control the operation of the second motor 13. For example, the second control circuit may include a main chip unit, a power chip unit, a communication unit, a decoder unit, a storage chip unit, a temperature acquisition unit, a signal amplification unit, a PWM output unit, and the like.

By integrating the second drive circuit and the second control circuit on the second circuit board, the integration degree of the motor controller 11 is effectively improved, thereby further reducing the volume of the motor controller 11.

In some embodiments of the present application, the first control module 1111 includes a first circuit board, where the first circuit board is provided with a first drive circuit and a first control circuit. The second control module 1121 includes a second circuit board. The second circuit board is provided with a second drive circuit and a second control circuit.

By integrating the first drive circuit and the first control circuit on the first circuit board and integrating the second drive circuit and the second control circuit on the second circuit board, the integration degree of the motor controller 11 is effectively improved, thereby further reducing the volume of the motor controller 11.

According to a second aspect, referring to FIGs. 3 and 4 together, an embodiment of the present application provides an electric drive apparatus 10 including a first motor 12, a second motor 13, and the motor controller 11 according to any one of the above embodiments, where the first control assembly 111 is electrically connected to the first motor 12, and the second control assembly 112 is electrically connected to the second motor 13.

Since the electric drive apparatus 10 provided by this embodiment of the present application adopts the motor controller 11 according to any one of the above embodiments, the volume of the electric drive apparatus 10 is effectively reduced.

In some embodiments of the present application, referring to FIG. 3, the motor controller 11 and the transmission mechanism 14 are arranged along a third direction, where the third direction is a direction perpendicular to the central axis of the first motor 12 and the central axis of the second motor 13. For example, the third direction is the direction X shown in FIG. 3.

By adopting the above technical solution, the structure of the electric drive apparatus 10 can be made more compact, thereby effectively reducing the volume of the electric drive apparatus 10.

In some embodiments of the present application, referring to FIGs. 3 and 6 together, the first direction and the third direction are the same. For example, the first direction and the third direction are each the direction X shown in FIGs. 3 and 6.

By adopting the above technical solution, a stacking direction of the first control assembly 111, the cooling assembly 113, and the second control assembly 112 is the same as a distribution direction of the motor controller 11 and the transmission mechanism 14, so that the thickness direction of the entirety formed by stacking the first control assembly 111, the cooling assembly 113, and the second control assembly 112 is consistent with a length direction of the electric drive apparatus 10 (for example, the direction X shown in FIG. 3), thereby effectively reducing the length of the electric drive apparatus 10 and further reducing the volume of the electric drive apparatus 10.

In some embodiments of the present application, the transmission mechanism 14 includes a first housing and a transmission assembly accommodated in the first housing, where the first housing and the box 118 are integrally formed.

The first housing is a component configured to provide an internal installation environment for the transmission mechanism 14. A material of the first housing may be but is not limited to copper, iron, aluminum, stainless steel, aluminum alloy, or the like, without specific limitation herein. In these embodiments, the first housing and the box 118 are integrally formed, that is, a material of the first housing is the same as a material of the box 118, and the first housing and the box 118 are manufactured as an entirety through an integral forming process. The integral forming process may be but is not limited to a die-casting process, a casting process, or the like, without specific limitation herein.

In some embodiments, the first motor 12 includes a second housing. The second motor 13 includes a third housing. The second housing and the third housing are separately disposed on two opposite sides of the first housing. For example, the second housing and the third housing are separately disposed on two opposite sides of the first housing along the direction Y shown in FIG. 3.

By adopting the above technical solution, the volume of the electric drive apparatus 10 is effectively reduced.

According to a third aspect, referring to FIG. 1, an embodiment of the present application provides an electric drive system 100 including a battery 20 and the electric drive apparatus 10 according to any one of the above embodiments, where the battery 20 is electrically connected to the electric drive apparatus 10.

Since the electric drive system 100 provided by this embodiment of the present application adopts the electric drive apparatus 10 according to any one of the above embodiments, the volume of the electric drive system 100 is effectively reduced.

According to a fourth aspect, referring to FIG. 1, an embodiment of the present application provides an electric device including the electric drive system 100 described above.

Since the electric device provided by this embodiment of the present application adopts the electric drive system 100 according to any one of the above embodiments, the volume of the electric device is effectively reduced.

The above description is merely preferred embodiments of the present application and is not intended to limit the present application. Any modifications, equivalent replacements, improvements, and the like, made within the spirit and principles of the present application should be included in the protection scope of the present application.

## Claims

1. A motor controller, **characterized in that** the motor controller comprises:
a first control assembly electrically connected to a first motor;
a second control assembly electrically connected to a second motor; and
a cooling assembly configured to cool the first control assembly and the second control assembly, wherein the first control assembly, the cooling assembly, and the second control assembly are sequentially stacked.

2. The motor controller according to claim 1, **characterized in that** the motor controller is disposed between the first motor and the second motor.

3. The motor controller according to claim 2, **characterized in that** the first control assembly, the cooling assembly, and the second control assembly are sequentially stacked along a first direction, wherein the first direction is a direction perpendicular to a central axis of the first motor and a central axis of the second motor.

4. The motor controller according to claim 3, **characterized in that** the motor controller further comprises a capacitor electrically connected to the first control assembly and the second control assembly, and a direct current input assembly electrically connected to the capacitor, wherein the first control assembly, the second control assembly, and the cooling assembly are disposed on one side of the capacitor, and the direct current input assembly is disposed on a side of the capacitor facing away from the first control assembly, the second control assembly, and the cooling assembly.

5. The motor controller according to claim 4, **characterized in that** the first control assembly, the second control assembly, and the cooling assembly are disposed on one side of the capacitor along a second direction, and the direct current input assembly is disposed on the other side of the capacitor along the second direction, wherein the second direction is a direction perpendicular to the first direction, the central axis of the first motor, and the central axis of the second motor.

6. The motor controller according to claim 5, **characterized in that**
the motor controller further comprises a first electrical connection member, wherein a first alternating current output terminal is disposed on a side of the first control assembly facing away from the capacitor, one end of the first electrical connection member is electrically connected to the first alternating current output terminal, and the other end of the first electrical connection member extends from the first alternating current output terminal to a side of the first control assembly facing the first motor and is electrically connected to an alternating current input terminal of the first motor; and/or
the motor controller further comprises a second electrical connection member, wherein a second alternating current output terminal is disposed on a side of the second control assembly facing away from the capacitor, one end of the second electrical connection member is electrically connected to the second alternating current output terminal, and the other end of the second electrical connection member extends from the second alternating current output terminal to a side of the second control assembly facing the second motor and is electrically connected to an alternating current input terminal of the second motor.

7. The motor controller according to claim 5 or 6, **characterized in that**
the motor controller further comprises a first sampling harness, wherein a first sampling terminal is disposed on the side of the first control assembly facing the first motor, one end of the first sampling harness is electrically connected to the first sampling terminal, and the other end of the first sampling harness is electrically connected to a sampling terminal of the first motor; and/or
the motor controller further comprises a second sampling harness, wherein a second sampling terminal is disposed on the side of the second control assembly facing the second motor, one end of the second sampling harness is electrically connected to the second sampling terminal, and the other end of the second sampling harness is electrically connected to a sampling terminal of the second motor.

8. The motor controller according to claim 1, **characterized in that** the motor controller further comprises a box, a capacitor electrically connected to the first control assembly and the second control assembly, and a direct current input assembly electrically connected to the capacitor, wherein the first control assembly, the second control assembly, the cooling assembly, the capacitor, and the direct current input assembly are accommodated in the box.

9. The motor controller according to claim 8, **characterized in that** the first control assembly, the second control assembly, the cooling assembly, the capacitor, and the direct current input assembly are connected and integrated into an entirety.

10. The motor controller according to claim 9, **characterized in that** the motor controller further comprises a first electrical connection member and a second electrical connection member, wherein one end of the first electrical connection member is electrically connected to the first control assembly, and the other end of the first electrical connection member is detachably connected to an alternating current input terminal of the first motor; one end of the second electrical connection member is electrically connected to the second control assembly, and the other end of the second electrical connection member is detachably connected to an alternating current input terminal of the second motor; an inner wall of the box is provided with a liquid inlet connector, a liquid outlet connector, and a direct current input terminal; the cooling assembly comprises a liquid inlet pipe detachably connected to the liquid inlet connector and a liquid outlet pipe detachably connected to the liquid outlet connector; and the direct current input assembly comprises a third electrical connection member detachably connected to the direct current input terminal.

11. The motor controller according to any one of claims 1 to 10, **characterized in that** the first control assembly comprises a first power module and a first control module; the second control assembly comprises a second power module and a second control module; and the first control module, the first power module, the cooling assembly, the second power module, and the second control module are sequentially stacked.

12. The motor controller according to claim 11, **characterized in that**
the cooling assembly comprises a liquid cooling plate, wherein a cooling flow channel is provided inside the liquid cooling plate;
the first power module comprises a first power body and a first heat conduction member, wherein the first heat conduction member is disposed on a side of the first power body facing the liquid cooling plate and inserted into the cooling flow channel; and/or
the second power module comprises a second power body and a second heat conduction member, wherein the second heat conduction member is disposed on a side of the second power body facing the liquid cooling plate and inserted into the cooling flow channel.

13. The motor controller according to claim 11 or 12, **characterized in that**
the first control module comprises a first circuit board, wherein the first circuit board is provided with a first drive circuit and a first control circuit; and/or
the second control module comprises a second circuit board, wherein the second circuit board is provided with a second drive circuit and a second control circuit.

14. An electric drive apparatus, **characterized in that** the electric drive apparatus comprises a first motor, a second motor, and the motor controller according to any one of claims 1 to 13, wherein the first control assembly is electrically connected to the first motor, and the second control assembly is electrically connected to the second motor.

15. An electric drive apparatus, **characterized in that** the electric drive apparatus comprises a first motor, a second motor, a transmission mechanism, and the motor controller according to any one of claims 3 to 7, wherein the first control assembly is electrically connected to the first motor, the second control assembly is electrically connected to the second motor, and the motor controller and the transmission mechanism are arranged along a third direction, wherein the third direction is a direction perpendicular to a central axis of the first motor and a central axis of the second motor.

16. The electric drive apparatus according to claim 15, **characterized in that** the first direction and the third direction are the same.

17. An electric drive apparatus, **characterized in that** the electric drive apparatus comprises a first motor, a second motor, a transmission mechanism, and the motor controller according to any one of claims 8 to 10, wherein the first control assembly is electrically connected to the first motor, the second control assembly is electrically connected to the second motor, the transmission mechanism comprises a first housing and a transmission assembly accommodated in the first housing, and the first housing and the box are integrally formed.

18. An electric drive system, **characterized in that** the electric drive system comprises a battery and the electric drive apparatus according to any one of claims 14 to 17, wherein the battery is electrically connected to the electric drive apparatus.

19. An electric device, **characterized in that** the electric device comprises the electric drive system according to claim 18.
